(19) Europäisches Patentamt
European Patent Office
Office européen des brevets

(11) **EP 3 176 949 B1**

(12) **EUROPEAN PATENT SPECIFICATION**

(45) Date of publication and mention
of the grant of the patent:
**11.09.2019 Bulletin 2019/37**

(51) Int Cl.:
*H03H 9/64* (2006.01)      *H03H 7/38* (2006.01)
*G01K 11/26* (2006.01)      *G06K 19/067* (2006.01)
*G06K 19/07* (2006.01)

(21) Application number: **15830363.6**

(22) Date of filing: **10.06.2015**

(86) International application number:
**PCT/CN2015/081119**

(87) International publication number:
**WO 2016/019756 (11.02.2016 Gazette 2016/06)**

(54) **DISTRIBUTED SURFACE ACOUSTIC WAVE RESONATOR AND SURFACE ACOUSTIC WAVE SENSING SYSTEM**

VERTEILTER OBERFLÄCHENSCHALLWELLENRESONATOR UND OBERFLÄCHENSCHALLWELLENSENSORSYSTEM

RÉSONATEUR À ONDES ACOUSTIQUES DE SURFACE RÉPARTIES ET SYSTÈME DE DÉTECTION D'ONDE ACOUSTIQUE DE SURFACE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.08.2014 CN 201410376054**

(43) Date of publication of application:
**07.06.2017 Bulletin 2017/23**

(73) Proprietor: **Mesnac Co. Ltd.**
**Qingdao, Shandong 266042 (CN)**

(72) Inventors:
• **DONG, Lanfei**
**Qingdao**
**Shandong 266042 (CN)**
• **TENG, Xuezhi**
**Qingdao**
**Shandong 266042 (CN)**
• **CHEN, Haijun**
**Qingdao**
**Shandong 266042 (CN)**
• **WEI, Jiangbo**
**Qingdao**
**Shandong 266042 (CN)**
• **TONG, Qiang**
**Qingdao**
**Shandong 266042 (CN)**

(74) Representative: **KIPA AB**
**P O Box 1065**
**251 10 Helsingborg (SE)**

(56) References cited:
**CN-A- 101 877 073        CN-A- 102 889 923
CN-U- 202 737 825        CN-U- 204 202 745
CN-U- 204 206 127        DE-A1- 19 851 002
US-A1- 2004 137 972      US-A1- 2004 159 154
US-A1- 2012 174 678**

• **QIUYUN FU ET AL: "Progress of matching network for passive remote hybrid sensor based on SAW resonator", ULTRASONICS SYMPOSIUM, 2008. IUS 2008. IEEE, IEEE, PISCATAWAY, NJ, USA, 2 November 2008 (2008-11-02), pages 1512-1515, XP031443234, DOI: 10.1109/ULTSYM.2008.0368 ISBN: 978-1-4244-2428-3**
• **XIANGWEN ZHANG ET AL: "Key Technologies of Passive Wireless Sensor Networks Based on Surface Acoustic Wave Resonators", NETWORKING, SENSING AND CONTROL, 2008. ICNSC 2008. IEEE INTERNATIONAL CONFERENCE ON, IEEE, PISCATAWAY, NJ, USA, 6 April 2008 (2008-04-06), pages 1253-1258, XP031255359,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

**Technical Field**

The present invention relates to a surface acoustic wave sensor, and particularly, relates to a distributed surface acoustic wave resonator.

**Background**

Radio frequency identification (RFID) technology is a technology applying contactless identification, which automatically identifies targeted objects through radio frequency signals and obtains relative data. One-port surface acoustic wave (SAW) resonator belongs to an important portion of the radio frequency identification products, comprising an interdigital transducer (IDT) and a reflection grating. The reflection grating is used to construct an acoustic cavity, and the IDT is used to conduct the sound-electronic interconversion.

The surface acoustic waves excited by the IDT on the surface of substrate reflect between reflection gratings back and forth and superimpose over each other. When the exciting frequency f of the external signal equals the central frequency of the SAW resonator f0, stationary waves are formed within the resonant cavity and resonance happens. The resonant frequency fO is an important characteristic parameter of the SAW resonator. Exoterical infinitesimal disturbance changes, such as reactive resistance value changes of the matching network, will change the central frequency f0. The changes of the central frequency fO will directly reflect the information being measured.

A passive wireless temperature sensing system of distributed surface acoustic wave measures different parameters respectively. Thus, the central frequencies are different in order to prevent the frequency interference problem caused by one central frequency. Whereas, such solution needs sensors with multiple central frequencies, which have complicated structure and need high manufacture costs.

China patent application with the publication number of CN101877073A relates to a field programmable surface acoustic wave radio frequency electronics identification. Each reflecting grating of said surface acoustic wave radio frequency electronics identification has touch spots in both two ends, and these distributed reflecting gratings are not interconnected; said surface acoustic wave radio frequency electronics identification further comprises integrated circuit chips with a switching function, which are stacked to the surface acoustic wave radio frequency electronics identification. The external touch spots of the integrated circuit are correspondingly set one to one to the touch spots of the reflection grating of the surface acoustic wave radio frequency electronics identification; and the integrated circuit can control open and short between any two touch spots in the distributed reflection grating through field programmable control switch circuit. In combination with the existing integrated circuits design, the disclosure of CN101877073A describes controlling open and short of each reflection grate bar in the reflection grating array, utilizing the switch array realized by the existing integrated circuits, and realizes field programmable surface acoustic wave radio frequency electronics identification, and improves multifunction and flexibility of the design. However, the surface acoustic wave radio frequency electronics identification of this structure has the following disadvantages: 1. one reflection grating can merely monitor one central frequency value if the integrated circuit chips are set onto the reflection grating. Multiple reflection gratings need to be set when multiple central frequency values need to be monitored. Correspondingly, piezoelectric substrates with bigger areas are needed for assembling reflection gratings. In one aspect, manufacture costs of the sensors are raised, and in another aspect, the volume of the sensors are enhanced. This attempt cannot satisfy the market's need of miniaturization. 2. Because of the energy loss caused by reflection transmission between the reflections gratings for sound wave, the sound wave will lose energy significantly when it arrives the last reflection grating if several reflection gratings are assembled. Correspondingly, the degree of sensitivity and reliability will be reduced. And if a signal suffers from relatively larger energy loss, its transmission distance is correspondingly shortened.

Wireless network based SAW sensors comprising SAW resonators are disclosed in the patent document DE 198 51 002 A1, and articles "Progress of matching network for passive remote hybrid sensor based on SAW resonator" by Qiuyun Fu et al. published in the 2008 IEEE International Ultrasonics Symposium Proceedings on 2 November 2008, and "Key Technologies of Passive Wireless Sensor Networks Based on Surface Acoustic Wave Resonators" by Xiangwen Zhang et al. published in the Proceedings of 2008 IEEE International Conference on Networking, Sensing and Control on 6 April 2008.

**Summary**

To solve the technical problem that existing surface acoustic wave sensors occupy a big volume, the present invention provides a wireless surface acoustic wave resonator system and a passive wireless temperature sensing system comprising such a wireless surface acoustic wave resonator system.

To solve the above-mentioned technical problem, the present invention adopts the following technical solution:

A wireless surface acoustic wave resonator system, comprising a first antenna, a matching network, a reflection grating, and an interdigital transducer, at least said reflection grating and said interdigital transducer assembled on a piezoelectric substrate, said matching network comprising an optimal matching network which is composed of at least one capacitor and at least one inductor, said matching network also comprising a switch circuit which is connected in parallel to said optimal matching network, said switch circuit comprising multiple branch circuits connected in parallel, each branch circuit comprising at least one capacitor and/or one inductor, said each branch circuit of the switch circuit also comprising a switch to control the conduction status of that branch circuit.

Furthermore, said switch circuit is a field programmable control switch circuit, and the switch of each branch circuit of said switch circuit is controlled by a field programmable control logic device.

Furthermore, said field programmable control logic device comprises n groups of external contact spots, and each branch circuit of said field programmable control switch circuit is connected to one group of external contact spots in series, and said field programmable control logic device controls the conduction status of each group of external contact spots by program, so as to connect or disconnect each branch circuit in the matching network, wherein n is not less than the number of branch circuits included in said switch circuit.

Furthermore, said wireless surface acoustic wave resonator system at most corresponds to $2^n$ central frequencies.

Wherein, said optimal matching network can be composed of the first capacitor (C1) and the first inductor (L1) which are connected in series; and said field programmable control switch circuit is connected in parallel with the two ends of the series circuit which is composed by the optimal matching network.

Or, said optimal matching network can be composed of the first capacitor (C1) and the first inductor (L1) which are connected in series; and said field programmable control switch circuit is connected in parallel with the two ends of the first inductor (L1).

Additionally, said optimal matching network can be composed of the first capacitor (C1) and the first inductor (L1) which are connected in series; and said field programmable control switch circuit is connected in parallel with the two ends of the first capacitor (C1).

Based on the above-mentioned wireless surface acoustic wave resonator system, the present invention also provides a passive wireless temperature sensing system, comprising a reader, a signal processing module, and a second antenna set on said reader, wherein said passive wireless temperature sensing system also comprises a wireless surface acoustic wave resonator system in accordance with any one described in the above paragraphs.

In comparison with the prior arts, the advantages and advantageous effects are: the present invention is a wireless surface acoustic wave resonator system; and a switch circuit is set in the matching network; and said switch circuit comprises multiple branch circuits installed in parallel; and each branch circuit comprises at least one capacitor and/or one inductor; when the matching network is connected to different branch circuits, the corresponding resonator corresponds to a central frequency in each case; therefore, the resonator's central frequency can be changed when the connected branch circuit is changed under control; the circuit can easily be realized and the circuit structure is simple and occupies small space; it is not necessary to increase the area of piezoelectric substrate, and the costs can be saved.

With the concrete description of embodiments of the present invention in conjunction with the figures, other characters and advantages of the present invention can be clearer.

**Brief Description of the Drawings**

In order to clearly describe the embodiments of the present invention or the technical solutions in the prior arts, the drawings which are needed for the description of the embodiments and the prior arts are briefly described as follows. Obviously, the drawings of the below descriptions are merely embodiments of the present invention. To the persons skilled in the art, other drawings can be obtained in accordance with these drawings without further creative efforts.

Figure 1 is the structural schematic diagram of an example of the wireless surface acoustic wave resonator system;
Figure 2 is the schematic block diagram of the matching network of the wireless surface acoustic wave resonator system in Figure 1;
Figure 3 is the schematic circuit diagram of the matching network in Figure 2;
Figure 4 is the equivalent circuit of the matching network circuit in Figure 3;
Figure 5 is the equivalent circuit model diagram of the resonator in Embodiment 2;
Figure 6 is the graphical chart of relationship between the resonator's reflection rate and frequency;
Figure 7 is the block diagram of one embodiment of a passive wireless temperature sensing system.

**Description of Embodiment**

In conjunction with the figures in the present invention's embodiments, technical solutions of the present invention's embodiments are clearly and completely described as follows. Obviously, said embodiments are not all embodiments but merely a portion of the embodiments of the present invention. Based on the embodiments in the present invention, other embodiments derived by the persons skilled in the art without further creative efforts are within the protection scope of the present invention.

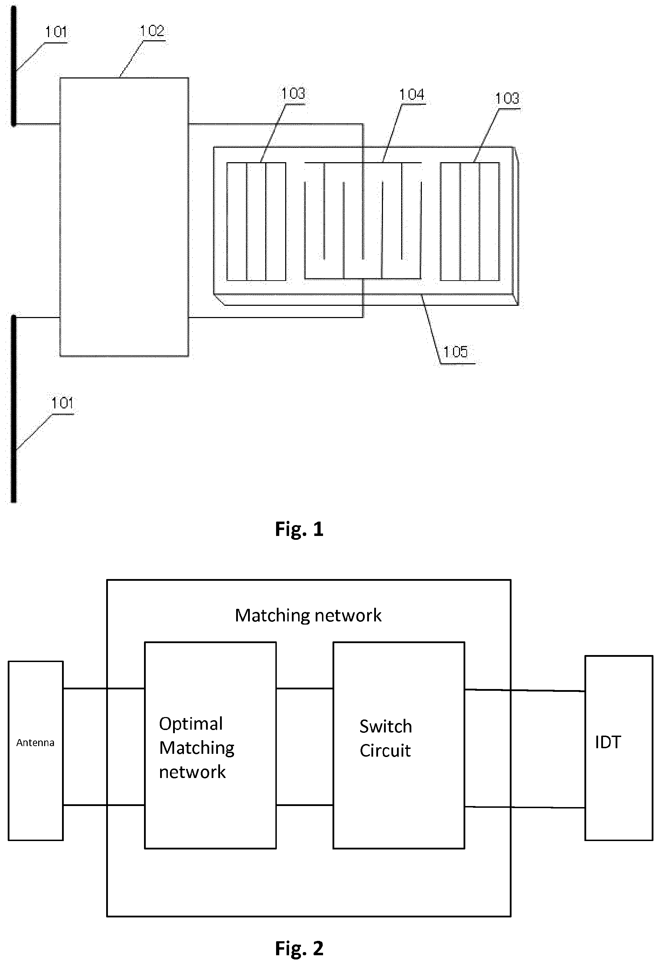

Figure 1 illustrates an example of a wireless surface acoustic wave resonator system, comprising an antenna 101, a matching network 102, a reflection grating 103, and an interdigital transducer 104, at least the reflection grating 103 and the interdigital transducer 104 are assembled on a piezoelectric substrate 105. As illustrated in figure 2, the matching network 102 comprises an optimal matching network which is composed of at least one capacitor and at least one inductor. The optimal matching network also connects to a switch circuit in parallel. Said switch circuit comprises multiple branch circuits which are connected in parallel. Each branch circuit comprises at least one conductor and/or one inductor. Each branch circuit of said switch circuit also comprises a switch which is used to control the conduction status of that branch circuit. Working principle of the wireless surface acoustic wave resonator system is: the antenna 101 receives an actuating signal; the present embodiment has an extra switch circuit in the matching network, through which the connected branch circuit is changed under control; the central frequency of the resonator is changed by that; and so is the central frequency of the signal, which is connected to the interdigital transducer from the matching network; therefore the resonator can be flexibly set to change its central frequencies, which are used to measure different parameters respectively in a passive wireless temperature sensing system of distributed surface acoustic wave, avoiding frequency interference problem caused by the central frequency. The circuit can be realized easily. The circuit structure is simple and occupies small space, and it is not necessary to increase the area of piezoelectric substrate, so as to save the total costs. It should be specified that the reactance components set on each branch circuit can respectively be capacitor(s) or inductor(s) alone, or can be a combination of capacitor(s) and inductor(s). The number of each reactance component set on the branch circuit can be any value as long as the central frequency value of the matching network can be changed when the branch circuit comprising such reactance components is connected. The surface acoustic wave resonator can be a one-port resonator or a two-port resonator.

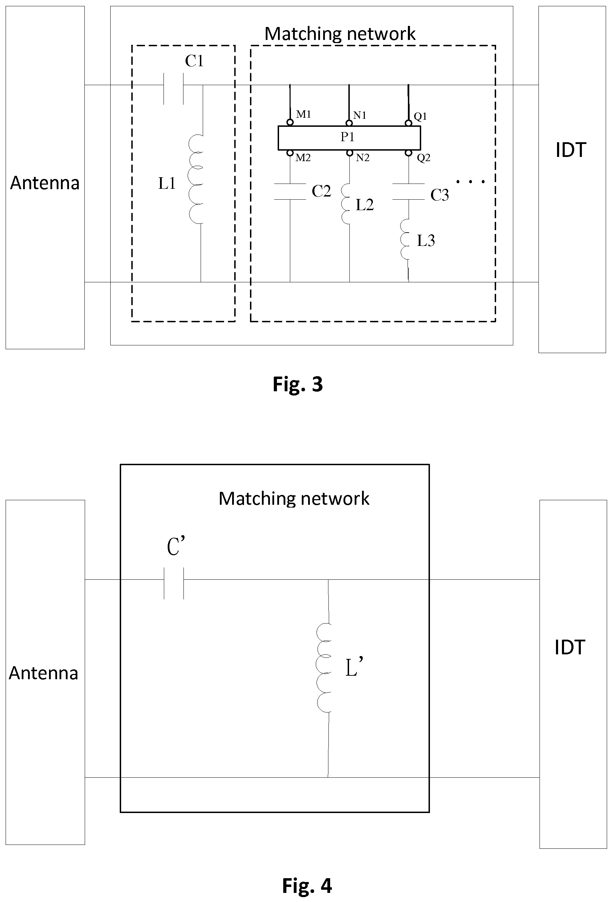

Embodiment 1 of the present invention provides a circuit of the wireless surface acoustic wave resonator system, wherein the switch circuit adopts a field programmable control switch circuit. As illustrated in Figure 3, the switch of each branch of said switch circuit is under the control of a field programmable control logic device P1.

The field programmable control logic device P1 comprises n groups of external contact spots. In Figure 3 of the present embodiment, 3 groups of external contact spots are provided and are respectively (M1, M2), (N1, N2), (Q1, Q2), which are respectively connected to 3 branch circuits of the switch circuit, i.e., each branch circuit of the switch circuit connects one group of external contact spots in series. The field programmable control logic device P1 controls the conduction status of each group of external contact spots by programming. For instance, when the field programmable control logic device P1 control the contact spots (M1, M2) to a conducting state, the capacitor C2 set in that branch circuit is connected to the matching network. The reactance value of the matching network is changed, and then the central frequency of the matching network is changed, when different branch circuit is connected to the matching network through the control of the field programmable control logic device P1, wherein n is not less than the number of branches comprised in said switch circuit. The present embodiment adopts a field programmable control logic device P1 for semicustom or full custom circuit design. The field programmable logic device ("PLD") can be in different forms: not only relatively easier devices such as PROM, EPROM, EEPROM, but also middle-and-high ranking devices such as PLA, PAL, GAL, EPLD, CPLD, FPGA and etc. The field programmable logic devices appearing to fulfil the users' design requirements have advantages of low power consumption, high speed, miniaturization, multi-functions, low costs, flexible design, unlimited repeatedly filed programming and etc. The field programmable logic devices can record the read-in data, control the characters of each port, and realize the connection and disconnection between each port.

The branch number n of the switch circuit does not limit to the examples raised in the present embodiment. The field programmable control logic device P1 controls the change of the conduction status of the external contact spots. Theoretically, the distributed surface acoustic wave resonator can correspond to $2^n$ central frequencies at the most and realize a functional expansion of the distributed surface acoustic wave resonator to the most. The central frequencies of multiple central resonators for measurement can be realized through an addition of the field programmable control logic device P1 to the matching network. Then distributive measurement can be carried out for multiple physical parameters in theory, while the central frequency of each resonator does not interfere with each other.

In the present embodiment, best matching network is composed of a first capacitor C1 and a first inductor L1 connected in series. As shown in the Figure 3, a field programmable control switch circuit is connected in parallel to two ports of a series circuit composed by said best matching network. The switch circuit and the best matching network jointly constitute T type matching network or become PI type matching network.

Or, said best matching network is composed of a first capacitor C1 and a first inductor L1 connected in series, said field programmable control switch circuit is connected in parallel to the two ports of the first inductor

Another, said best matching network is composed of a first capacitor C1 and a first inductor L1 connected in series, said field programmable control switch circuit is connected in parallel to the two ports of the first capacitor L1.

The above mentioned two solutions are not shown in the figures but variations of the first solution. The persons skilled in the art can deduce these solutions reviewing the first solution without creative efforts. No additional specifications are mentioned herein.

A basic principle of the wireless surface acoustic wave resonator system will now be described. Because different capacitors and/or inductors are connected in series to each branch circuit, the reactance value of the matching network will be changed whenever any branch circuit is newly connected to the matching network. The present embodiment provides another way of connection. As illustrated in Figure 4, equivalent capacitive reactance of the matching network is C', and equivalent inductive reactance of the matching network is L'. The method to calculate the resistance value of the matching network Zeq2 is:

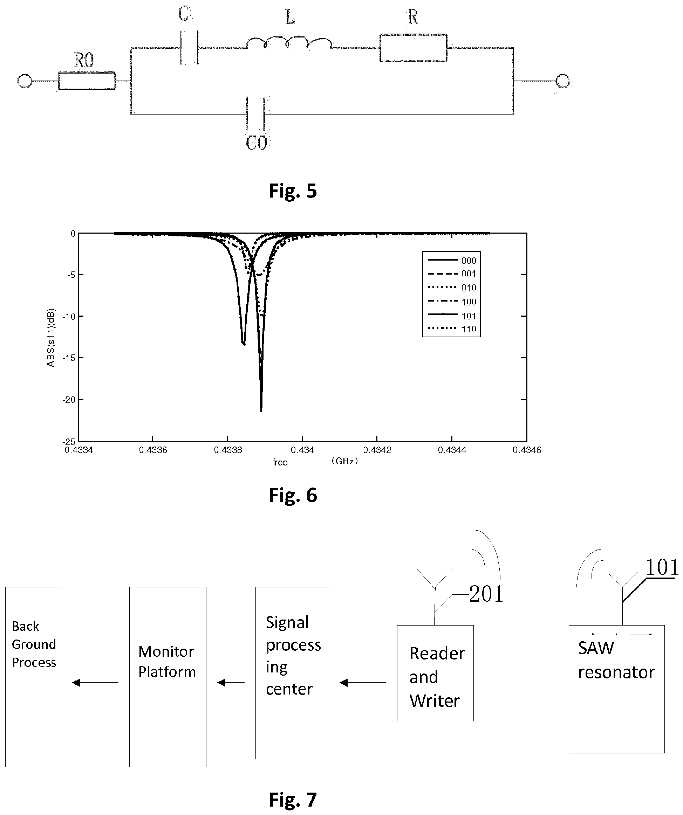

The equivalent circuit model of generic resonator of the resonator is illustrated in Figure 5. C and L in Figure 5 are respectively dynamic capacitor and inductor induced by elasticity and inertia of piezoelectric substrates. R is the dynamic resistance raised by damping, and C0 is the static capacitor of the interdigital transducer; and R0 is the lead wire resistance. The equivalent circuit of the resonator comprises 5 parameters, including R0, R, L, C and C0.

The method to calculate the impedance of the resonator Zeq1 is:

$$Zeq1 = R0 + \cfrac{1}{jwC0 + \cfrac{1}{R + jwL + \cfrac{1}{jwC}}} \qquad (3)$$

Zeq is the equivalent impedance of the structure composed by the resonator Zeq 1 and the matching network Zeq2, i.e. the total impedance value of the whole structure, therefore,

$$Zeq = Zeq1 + Zeq2 \qquad (4)$$

In general, the characteristic impedance of commonly used transmission line is $50\Omega$, and the matching point is corresponding to the central frequency of S11, which is the frequency with the smallest amplitude. The reflection coefficient is:

$$S11 = \frac{Zeq - 50}{Zeq + 50} \qquad (5)$$

Relationship curve of the S11 and frequency f can be obtained from the above equations (1~5). The frequency with the smallest amplitude fO corresponds to the central frequency of S11. In the matching network, if the capacitor or the inductor of the external sensor is connected to the network. the equivalent value of C1 or L1 will be changed and the value of Zeq2 will be influenced, and finally the curve chart of S11 will be influenced. The frequency fO with the smallest amplitude, i.e. the central frequency of the whole resonator structure changes correspondingly.

A concrete structure of the wireless surface acoustic wave resonator system is provided, wherein the piezoelectric substrate adopts ST Quartz wafer of 0.35mm. The resonance frequency of the resonator is selected within the ISM frequency band of 433.92MHz, the finger width is $3.68\mu m$, and the finger duty ratio is determined to be 0.5.

The film of the interdigital transducer is 2500 Å thick (250 nm). The wave length is $7.19\mu m$. The diameter of the sound hole is $358\mu m$. And there are 101 pairs of Split-Fingers and 200 pairs of reflecting gratings. The separated width between the interdigital transducer finger and the reflecting grating finger is $1.79\mu m$. The resonator equivalent circuit parameter lead wire resistance R0 is $5\Omega$, and the dynamic impedance caused by the damping is $63.3\Omega$. The dynamic inductor L induced by elasticity and inertia of piezoelectric substrates is $4.511 \times 10^5 nH$, and the dynamic capacitor C induced by elasticity and inertia of piezoelectric substrates is $2.983 \times 10^{-7}$ nF, and the static capacitor of the interdigital transducer is $7.0 \times 10^{-4} nF$. When C1=1.2pF and L1=96.1nH compose the best matching network, L2 is 20nH, L3 is 85nH, and L4 is 92nH. The branch control spot of the field programmable control logic device has 3 bits, from the left to the right representing the connection status of each branch circuit, as that: 000 representing all contact spots are open, and the central frequency of the resonator is 433.90MHz ; 100 representing contact spots (M1, M2) are connected, and the central frequency of the resonator is 433.84MHz; 010 representing (N1, N2) are connected, and the central frequency of the resonator is 433.86MHz; 001 representing contact spots (Q1,Q2) are connected, and the central frequency of the resonator is 433.88MHz. Furthermore, it can be calculated that when the code of the field programmable control logic device PI is 101, the central frequency of the resonator is 433.82MHz; and when the code is 110, the central frequency of the resonator is 433.81MHz. Relationship between the resonator reflection rate S11 and frequency is shown in Figure 6. It can be seen that all the central frequencies are neither the same nor could cause any interference.

Embodiment of the present invention provides a passive wireless temperature sensing system based on the wireless surface acoustic wave resonator system of embodiment 1. As shown in Figure 7, the passive wireless temperature sensing system comprises a reader, a signal processing module, said reader comprising a second antenna 201, a first antenna 101 at the wireless SAW resonator system, and both antennas communicate with each other. As shown in Figure 2, the wireless SAW resonator system also comprises a matching network 102, a reflection grating 103, and an interdigital transducer 104, in which at least the reflection grating 103 and the interdigital transducer 104 are assembled onto the piezoelectric substrate 105. As shown in Figure 3, the matching network 102 comprises an optimal matching network which is composed of at least one capacitor C1 and at least one inductor L1. Said optimal matching network also connects a switch circuit in parallel, and said switch circuit comprises several branch circuits connected in parallel. Each branch circuit has at least one capacitor and/or an inductor device. Each branch circuit of said switch circuit comprises a switch to control the conductive status of that branch. The principle of the passive wireless temperature sensing system of the present embodiment is: the reader sends an activated signal to the wireless SAW resonator system through the second antenna 201, and the wireless SAW resonator system receives the activated signal through the first antenna 101, and through an additional switch circuit in the matching network of the wireless SAW resonator system, the branch to be connected is controlled and changed, thus the central frequency of the resonator is changed, so that the central frequency connected to the interdigital transducer through the matching network is changed, and a resonator whose central frequency can be flexibly set is realized.

Certainly, the above description does not constitute limitations of the present invention, and the present invention shall not be limited to the above embodiments. The person skilled in the art can make changes, adjustments, additions, and replacements based on the substantive scope of the present invention, and those contents also belong to the protection scope of the present invention.

## Claims

1. A wireless surface acoustic wave resonator system, comprising a first antenna (101), a matching network (102), a reflection grating (103), and an interdigital transducer (104), with at least said reflection grating (103) and said interdigital transducer (104) assembled on a piezoelectric substrate (105), said matching network (102) comprising an optimal matching network which is composed of at least one capacitor (C1) and at least one inductor (L1), said matching network (102) also comprising a switch circuit which is connected in parallel to said optimal matching network, said switch circuit comprising multiple branch circuits connected in parallel, each branch circuit comprising at least one capacitor (C2, C3) and/or one inductor (L2, L3), said each branch circuit of the switch circuit also comprising a switch to control the conduction status of that branch circuit; wherein said switch circuit is a field programmable control switch circuit, and the switch of each branch circuit of said switch circuit is controlled by a field programmable control logic device (P1);

   **characterized in that** said field programmable control logic device (P1) comprises n groups of external contact spots((M1, M2), (N1, N2), (Q1, Q2)), and each branch circuit of said field programmable control switch circuit is connected to one group of external contact spots((M1, M2), (N1, N2), (Q1, Q2)) in series, and said field programmable control logic device (P1) controls the conduction status of each group of external contact spots ((M1, M2), (N1, N2), (Q1, Q2)) by programming, so as to connect or disconnect each branch circuit in the matching network, wherein n is not less than the number of branch circuits included in said switch circuit.

2. The wireless surface acoustic wave resonator system according to claim 1, **characterized in that** said wireless surface acoustic wave resonator system at most corresponds to $2^n$ central frequencies.

3. The wireless surface acoustic wave resonator system according to any one of claims 1-2, **characterized in that** said optimal matching network is composed of the first capacitor (C1) and the first inductor (L1) which are connected in series; and said field programmable control switch circuit is connected in parallel with the two ends of the series circuit which is composed by the optimal matching network.

4. The wireless surface acoustic wave resonator system according to any one of claims 1-2, **characterized in that** said optimal matching network is composed of a first capacitor (C1) and a first inductor (L1) which are connected in series; and said field programmable control switch circuit is connected in parallel with the two ends of the first inductor (L1).

5. The wireless surface acoustic wave resonator system according to any one of claims 1-2, **characterized in that** said optimal matching network is composed of a first capacitor (C1) and a first inductor (L1) which are connected in series; and said field programmable control switch circuit is connected in parallel with the two ends of the first capacitor (C1).

6. A passive wireless temperature sensing system, comprising a reader, a signal processing module, a second antenna (201) set on said reader, wherein said wireless temperature sensing system also comprises a wireless surface acoustic wave resonator system in accordance with any one of claims 1-5.

## Patentansprüche

1. Ein drahtloses Resonatorsystem für akustische Oberflächenwellen, mit einer ersten Antenne (101), einem Anpassungsnetzwerk (102), einem Reflektionsgitter (103) und einem Interdigitaltransducer (104), wobei zumindest das vorerwähnte Reflektionsgitter (103) und der vorerwähnte Interdigitaltransducer (104) auf einem piezoelektrischen Substrat (105) montiert sind, das dazugehörige Netzwerk (102) ein optimales Anpassungsnetzwerk aufweist, das aus mindestens einem Kondensator (C1) und mindestens einer Spule (L1) besteht und das vorerwähnte Anpassungsnetzwerk (102) weiterhin einen Schaltkreis aufweist, der parallel an das vorerwähnte optimale Anpassungsnetzwerk angeschlossen ist, der vorerwähnte Schaltkreis mehrere parallel angeschlossene Zweigstromkreise aufweist, jeder Zweigstromkreis mindestens einen Kondensator (C2, C3) und/oder eine Spule (L2/L3) aufweist und jeder vorerwähnte Zweigstromkreis des Schaltkreises weiterhin einen Schalter zur Steuerung des Leitstatus jedes Zweigstromkreises aufweist; wobei es sich bei dem vorerwähnten Schaltkreis um einen anwenderprogrammierbaren Steuerschaltkreis handelt und der Schalter eines jeden Zweigstromkreises des vorerwähnten Schaltkreises durch einen anwenderprogrammierbaren Logikbaustein (P1) gesteuert wird; **dadurch gekennzeichnet, dass** der vorerwähnte anwenderprogrammierbare Logikbaustein (P1) n Gruppen externer Kontaktstellen ((M1, M2), (N1, N2), (Q1, Q2)) aufweist und jeder Zweigstromkreis des vorerwähnten anwenderprogrammierbaren Steuerschaltkreises in Reihe an eine Gruppe externer Kontaktstellen ((M1, M2), (N1, N2), (Q1, Q2)) angeschlossen ist, und der vorerwähnte anwenderprogrammierbare Logikbaustein (P1) den Leitstatus jeder Gruppe externer Kontaktstellen ((M1, M2), (N1, N2), (Q1, Q2)) steuert, indem er zum Verbinden bzw. Trennen jedes Zweigstromkreises im Anpassungsnetzwerk programmiert wird, wobei n nicht kleiner als die Anzahl der Zweigstromkreise im vorerwähnten Schaltkreis ist.

2. Das drahtlose Resonatorsystem für akustische Oberflächenwellen gemäß Anspruch 1, **dadurch gekennzeichnet, dass** das vorerwähnte drahtlose Resonatorsystem für akustische Oberflächenwellen höchstens $2^n$ Mittelfrequenzen aufweist.

3. Das drahtlose Resonatorsystem für akustische Oberflächenwellen gemäß einem der Ansprüche 1-2, **dadurch gekennzeichnet, dass** das vorerwähnte optimale Anpassungsnetzwerk aus dem ersten Kondensator (C1) und der ersten Spule (L1) besteht, die in Reihe geschaltet sind; und der vorerwähnte anwenderprogrammierbare Steuerschaltkreis parallel zu den beiden Enden der Reihenschaltung des optimalen Anpassungsnetzwerks angeschlossen ist.

4. Das drahtlose Resonatorsystem für akustische Oberflächenwellen gemäß einem der Ansprüche 1-2, **dadurch gekennzeichnet, dass** das vorerwähnte optimale Anpassungsnetzwerk aus einem ersten Kondensator (C1) und einer ersten Spule (L1) besteht, die in Reihe geschaltet sind; und der vorerwähnte anwenderprogrammierbare Steuerschaltkreis parallel zu den beiden Enden der ersten Spule (L1) angeschlossen ist.

5. Das drahtlose Resonatorsystem für akustische Oberflächenwellen gemäß einem der Ansprüche 1-2, **dadurch gekennzeichnet, dass** das vorerwähnte optimale Anpassungsnetzwerk aus einem ersten Kondensator (C1) und einer ersten Spule (L1) besteht, die in Reihe geschaltet sind; und der vorerwähnte anwenderprogrammierbare Steuerschaltkreis parallel zu den beiden Enden des ersten Kondensators (C1) angeschlossen ist.

6. Ein drahtloses passives Temperaturfühlersystem, bestehend aus einer Leseeinheit, einem Signalverarbeitungsmodul und einer an der vorerwähnten Leseeinheit eingestellten zweiten Antenne (201), wobei das vorerwähnte drahtlose System weiterhin ein drahtloses Resonatorsystem für akustische Oberflächenwellen gemäß einem der Ansprüche 1-5 aufweist.

**Revendications**

1. Système de résonateur à ondes acoustiques de surface sans fil, comprenant une première antenne (101), un réseau d'adaptation (102), un réseau de réflexion (103), et un transducteur interdigité (104), où au moins ledit réseau de réflexion (103) et ledit transducteur interdigité (104) sont assemblés sur un substrat piézoélectrique (105), ledit réseau d'adaptation (102) comprenant un réseau d'adaptation optimale lequel est composé d'au moins un condensateur (C1) et d'au moins une bobine d'inductance (L1), ledit réseau d'adaptation (102) comprenant également un circuit de commutation lequel est branché en parallèle aux bornes dudit réseau d'adaptation optimale, ledit circuit de commutation comprenant de multiples circuits de branche branchés en parallèle, chaque circuit de branche comprenant au moins un condensateur (C2, C3) et/ou une bobine d'inductance (L2, L3), chaque dit circuit de branche du circuit de commutation comprenant également un commutateur pour commander l'état de conduction de ce circuit de branche ; où ledit circuit de commutation est un circuit de commutation à commande programmable par l'utilisateur, et la commutation de chaque circuit de branche dudit circuit de commutation est commandée par un dispositif à logique de commande programmable par l'utilisateur (P1) ;
   **caractérisé en ce que** ledit dispositif à logique de commande programmable par l'utilisateur (P1) comprend n groupes de points de contact externes ((M1, M2), (N1,N2), (Q1, Q2)), et chaque circuit de branche dudit circuit de commutation à commande programmable par l'utilisateur est branché à un seul groupe de points de contact externes ((M1, M2), (N1, N2), (Q1, Q2)) en série, et ledit dispositif à logique de commande programmable par l'utilisateur (P1) commande l'état de conduction de chaque groupe de points de contact externes ((M1, M2), (N1, N2), (Q1, Q2)) via une programmation, de sorte à connecter ou déconnecter chaque circuit de branche dans le réseau d'adaptation, où n n'est pas inférieur au nombre de circuits de branche inclus dans ledit circuit de commutation.

2. Système de résonateur à ondes acoustiques de surface sans fil selon la revendication 1, **caractérisé en ce que** ledit système de résonateur à ondes acoustiques de surface sans fil correspond au plus à $2^n$ fréquences centrales.

3. Système de résonateur à ondes acoustiques de surface sans fil selon l'une quelconque des revendications 1 et 2, **caractérisé en ce que** ledit réseau d'adaptation optimale est composé du premier condensateur (C1) et de la première bobine d'inductance (L1) lesquels sont branchés en série ; et ledit circuit de commutation à commande programmable par l'utilisateur est branché en parallèle aux bornes du circuit en série lequel est composé par le réseau d'adaptation optimale.

4. Système de résonateur à ondes acoustiques de surface sans fil selon l'une quelconque des revendications 1 et 2, **caractérisé en ce que** ledit réseau d'adaptation optimale est composé d'un premier condensateur (C1) et d'une première bobine d'inductance (L1) lesquels sont branchés en série ; et ledit circuit de commutation à commande programmable par l'utilisateur est branché en parallèle aux bornes de la première bobine d'inductance (L1).

5. Système de résonateur à ondes acoustiques de surface sans fil selon l'une quelconque des revendications 1 et 2, **caractérisé en ce que** ledit réseau d'adaptation optimale est composé d'un premier condensateur (C1) et d'une première bobine d'inductance (L1) lesquels sont branchés en série ; et ledit circuit de commutation à commande programmable par l'utilisateur est branché en parallèle aux bornes du premier condensateur (C1).

6. Système de détection de température passif sans fil, comprenant un lecteur, un module de traitement de signal, une deuxième antenne (201) située sur ledit lecteur, où ledit système de détection de température sans fil comprend également un système de résonateur à ondes acoustiques de surface sans fil selon l'une quelconque des revendications 1 à 5.

**Fig. 1**

**Fig. 2**

**Matching network**

Antenna

C1

M1   N1   Q1

P1

M2   N2   Q2

L1

C2   L2   C3   · · ·

L3

IDT

**Fig. 3**

**Matching network**

Antenna

C'

L'

IDT

**Fig. 4**

**Fig. 5**

**Fig. 6**

**Fig. 7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 101877073 A

- DE 19851002 A1

**Non-patent literature cited in the description**

- **QIUYUN FU et al.** Progress of matching network for passive remote hybrid sensor based on SAW resonator. *2008 IEEE International Ultrasonics Symposium Proceedings,* 02 November 2008

- **XIANGWEN ZHANG et al.** Key Technologies of Passive Wireless Sensor Networks Based on Surface Acoustic Wave Resonators. *Proceedings of 2008 IEEE International Conference on Networking, Sensing and Control,* 06 April 2008